# EUROPÄISCHE PATENTANMELDUNG

(11) **EP 1 906 499 A1**
(43) Veröffentlichungstag der Anmeldung: **02.04.2008**
(21) Anmeldenummer: 07115143.5
(22) Anmeldetag: 28.08.2007
(51) Int. Cl.: H01S 5/40, H01S 5/024, H01S 5/042, H01S 5/32, H01S 5/34

(54) **Kantenemittierender Halbleiterlaser mit mehreren monolithisch integrierten Laserdioden**

(30) Priorität: 27.12.2006 DE 102006061532; 28.09.2006 DE 102006046036
(71) Anmelder: OSRAM Opto Semiconductors GmbH, 93055 Regensburg (DE)
(72) Erfinder: Philippens, Marc, 93049 Regensburg (DE); Brick, Peter, 93051 Regensburg (DE); Müller, Martin, 93128 Regenstauf (DE); Luft, Johann, 93195 Wolfsegg (DE)
(74) Vertreter: Epping - Hermann - Fischer

(57) **Zusammenfassung**

Bei einem kantenemittierenden Halbleiterlaser, der mehrere monolithisch integrierte Laserdioden (1, 2, 3) enthält, wobei jede Laserdiode (1, 2, 3) eine aktive Zone (11, 12, 13) enthält, sind die aktiven Zonen (11, 12, 13) jeweils zwischen Wellenleiterschichten (6) angeordnet, wobei die Wellenleiterschichten (6) an einer von der aktiven Zone (11, 12, 13) abgewandten Seite jeweils an eine Mantelschicht (7, 8) angrenzen, und wobei die Mantelschichten (7, 8) innere Mantelschichten (7), die oberhalb einer untersten aktiven Zone (11) und unterhalb einer obersten aktiven Zone (13) angeordnet sind, und äußere Mantelschichten (8), die unterhalb der untersten aktiven Zone (11) oder oberhalb der obersten aktiven Zone (13) angeordnet sind, umfassen. Die inneren Mantelschichten (7) weisen dabei eine geringere Dicke auf als die äußeren Mantelschichten (8).

## Beschreibung

Die Erfindung betrifft einen kantenemittierenden Halbleiterlaser mit mehreren monolithisch integrierten Laserdioden gemäß dem Oberbegriff des Patentanspruchs 1.

Diese Patentanmeldung beansprucht die Priorität der deutschen Patentanmeldungen 10 2006 061 532.8 und 10 2006 046 036.7, deren Offenbarungsgehalt hiermit durch Rückbezug aufgenommen wird.

Zum Erreichen hoher optischer Ausgangsleistungen bei kantenemittierenden Halbleiterlasern ist es bekannt, mehrere Laserdioden in einem Schichtstapel monolithisch zu integrieren. Beispielsweise ist aus der Druckschrift US 5,212,706 ein kantenmittierender Halbleiterlaser bekannt, bei dem mehrere Laserdioden monolithisch übereinander abgeschieden sind und die Laserdioden mittels Tunnelübergängen miteinander verbunden sind.

Die vergleichsweise große Dicke des Schichtstapels eines derartigen kantenemittierenden Halbleiterasers mit mehreren monolithisch integrierten Laserdioden wirkt sich nachteilig auf die Wärmeleitung aus. Die Wärmeabfuhr der von den Laserdioden erzeugten Wärme ist daher im Vergleich zu einem einfachen Halbleiterlaser erschwert.

Weiterhin kann das Problem bestehen, dass die aktiven Zonen der übereinander angeordneten Laserdioden beim Betrieb des kantenemittierenden Halbleiterlasers zumindest geringfügig unterschiedliche Temperaturen aufweisen. Dies kann zu unerwünschten Differenzen der Emissionswellenlängen der einzelnen Laserdioden führen.

Da bei einem kantenmittierenden Halbleiterlaser mit mehreren monolithisch integrierten Laserdioden ein vergleichsweise dicker Schichtstapel abgeschieden wird, ist die Herstellung vergleichsweise aufwändig.

Der Erfindung liegt die Aufgabe zugrunde, einen kantenemittierenden Halbleiterlaser mit mehreren monolithisch integrierten Laserdioden anzugeben, der sich insbesondere durch eine verbesserte Wärmeabfuhr der von den einzelnen Laserdioden erzeugten Wärme, einen verringerten Temperaturunterschied der aktiven Zonen der Laserdioden und einen vergleichsweise geringen Herstellungsaufwand auszeichnet.

Diese Aufgabe wird durch einen kantenemittierenden Halbleiterlaser mit den Merkmalen des Patentanspruchs 1 gelöst. Vorteilhafte Ausgestaltungen und Weiterbildungen der Erfindung sind Gegenstand der abhängigen Ansprüche.

Bei einem kantenemittierenden Halbleiterlaser, der mehrere monolithisch integrierte Laserdioden enthält, wobei jede Laserdiode eine aktive Zone enthält, sind die aktiven Zonen jeweils zwischen Wellenleiterschichten angeordnet, wobei die Wellenleiterschichten an einer von der aktiven Zone abgewandten Seite jeweils an eine Mantelschicht angrenzen. Die Mantelschichten umfassen innere Mantelschichten, die oberhalb einer untersten aktiven Zone und unterhalb einer obersten aktiven Zone angeordnet sind, und äußere Mantelschichten, die unterhalb der untersten aktiven Zone oder oberhalb der obersten aktiven Zone angeordnet sind. Die inneren Mantelschichten weisen eine geringere Dicke auf als die äußeren Mantelschichten.

Bei dem kantenemittierenden Halbleiterlaser sind also die aktiven Schichten jeweils in Wellenleiterschichten eingebettet, wodurch die von den aktiven Zonen der Laserdioden emittierte Laserstrahlung in lateraler Richtung geführt wird. Der Wellenleiter entsteht durch einen Brechungsindexsprung zwischen den Wellenleiterschichten und den angrenzenden Mantelschichten, wobei die Mantelschichten typischerweise einen geringeren Brechungsindex als die Wellenleiterschichten aufweisen. Aufgrund der endlichen Brechungsindexdifferenz dringt das Strahlungsfeld des Halbleiterlasers aber zumindest teilweise in die Mantelschichten ein. Zur Verminderung von Absorptionsverlusten in den an die Mantelschichten angrenzenden Schichten, beispielsweise einem Aufwachsubstrat oder Kontaktschichten, sind die Mantelschichten bei herkömmlichen Halbleiterlasern vergleichsweise dicke Schichten mit einer Dicke von typischerweise etwa 1 µm bis 2 µm.

Dadurch, dass bei dem erfindungsgemäßen Halbleiterlaser die zwischen der untersten aktiven Zone und der obersten aktiven Zone angeordneten inneren Mantelschichten eine geringere Dicke aufweisen als die äußeren Mantelschichten, die beispielsweise zwischen einem Substrat und der untersten aktiven Zone und zwischen der obersten aktiven Zone und einer zur elektrischen Kontaktierung vorgesehenen Kontaktschicht angeordnet sind, vermindert sich die Dicke des Schichtstapels aus den mehreren Laserdioden. Aufgrund der verringerten Schichtdicken der inneren Mantelschichten wird auch der thermische Widerstand dieser Schichten kleiner, wodurch eine effizientere Kühlung des kantenemittierenden Halbleiterlasers ermöglicht wird. Weiterhin weisen die inneren Mantelschichten aufgrund der verringerten Schichtdicken auch einen kleineren elektrischen Widerstand auf, wodurch ebenfalls die Erwärmung des kantenemittierenden Halbleiterlasers im Betrieb reduziert wird.

Weiterhin wird die zur Abscheidung des Schichtstapels erforderliche Abscheidezeit aufgrund der verringerten Schichtdicken der inneren Mantelschichten verkürzt, wodurch der Zeit- und Materialbedarf vermindert werden und somit die Herstellungskosten reduziert werden.

Aufgrund des verminderten thermischen Widerstands der inneren Mantelschichten sind die Temperaturunterschiede zwischen den mehreren aktiven Zonen geringer, als wenn die inneren Mantelschichten mit der gleichen Dicke wie die äußeren Mantelschichten abgeschieden würden.

Weiterhin werden durch die verringerten Schichtdicken der inneren Mantelschichten auch innerhalb des Schichtstapels auftretende Verspannungen vermindert. Die durch die verringerten Schichtdicken der inneren Mantelschichten geringeren auftretenden Verspannungen ermöglichen vorteilhaft die monolithische Integration einer größeren Anzahl von Laserdioden als bei herkömmlichen kantenemittierenden Halbleiterlasern mit mehreren monolithisch integrierten Laserdioden. Insbesondere kann der kantenemittierende Halbleiterlaser vier oder mehr Laserdioden, besonders bevorzugt sogar fünf oder mehr Laserdioden aufweisen.

Weiterhin wird durch die vergleichsweise geringe Dicke der inneren Mantelschichten die Stromaufweitung innerhalb des Schichtstapels vermindert, d.h. der Stromfluss durch den Schichtstapel erfolgt im Wesentlichen durch einen Bereich des Schichtstapels, der mit einer vorzugsweise strukturierten Kontaktschicht versehen ist. Beispielsweise kann der Stromfluss mittels eines streifenförmig strukturierten Kontakts auf einen streifenförmigen Bereich des Schichtstapels eingrenzt werden. Die Laserschwelle wird dadurch vorteilhaft reduziert.

Bei einer vorteilhaften Ausführungsform der Erfindung sind die inneren Mantelschichten um mindestens einen Faktor 2 dünner als die äußeren Mantelschichten.

Bevorzugt sind die inneren Mantelschichten um mindestens einen Faktor 5, besonders bevorzugt sogar um einen Faktor 10 dünner als die äußeren Mantelschichten.

Die inneren Mantelschichten weisen bevorzugt jeweils eine Dicke von 300 nm oder weniger auf. Besonders bevorzugt beträgt die Dicke der inneren Mantelschichten sogar 100 nm oder weniger. Die Dicke der inneren Mantelschichten ist also vorteilhaft wesentlich geringer als die Dicke der Mantelschichten bei herkömmlichen kantenemittierenden Halbleiterlasern, die etwa 1 µm bis 2 µm beträgt.

Die äußeren Mantelschichten weisen jeweils eine Dicke von 500 nm oder mehr, oder bevorzugt von 1 µm oder mehr auf. Durch die vergleichsweise dicken äußeren Mantelschichten wird eine Absorption der emittierten Laserstrahlung in einem Substrat, das beispielsweise zum Aufwachsen des Schichtstapels verwendet wird, und in einer Kontaktschicht, die zum Beispiel an einer dem Substrat gegenüber liegenden Oberfläche des Schichtstapels zur elektrischen Kontaktierung des kantenemittierenden Halbleiterlasers aufgebracht ist, vermindert.

Der kantenemittierende Halbleiterlaser kann beispielsweise zwei oder drei Laserdioden aufweisen. Insbesondere ist es aber auch möglich, dass der kantenemittierende Halbleiterlaser vier oder mehr, bevorzugt sogar fünf oder mehr Laserdioden aufweist. Die Anordnung einer Vielzahl von monolithisch integrierten Laserdioden in dem Schichtstapel des kantenemittierenden Halbleiterlasers wird durch die verringerte Dicke der inneren Mantelschichten erleichtert, da durch die geringeren Dicken Schichtspannungen vermindert sind, die bei einer Vielzahl von monolithisch integrierten Laserdioden zu einer Beeinträchtigung der Schichtqualität oder sogar zur Zerstörung des Schichtstapels führen könnten. Außerdem werden Abweichungen der Emissionswellenlängen der einzelnen Laserdioden, die in dem Schichtstapel durch geringfügig verschiedene Temperaturen der einzelnen aktiven Zonen auftreten könnten, durch die vergleichsweise dünnen inneren Mantelschichten vermindert.

Die aktiven Zonen der mehreren Laserdioden weisen bevorzugt eine Quantentopfstruktur, insbesondere eine Einfach-Quantentopfstruktur, auf. Weiterhin kann die Quantentopfstruktur auch eine Mehrfach-Quantentopfstruktur sein. Die Bezeichnung Quantentopfstruktur umfasst im Rahmen der Anmeldung jegliche Struktur, bei der Ladungsträger durch Einschluss ("confinement") eine Quantisierung ihrer Energiezustände erfahren. Insbesondere beinhaltet die Bezeichnung Quantentopfstruktur keine Angabe über die Dimensionalität der Quantisierung. Sie umfasst somit u.a.

Quantentröge, Quantendrähte und Quantenpunkte und jede Kombination dieser Strukturen.

Bei einer bevorzugten Ausführungsform der Erfindung unterscheiden sich die Einfach- oder Mehrfach-Quantentopfstrukturen der mehreren aktiven Zonen in ihren Schichtdicken und/oder ihren Materialzusammensetzungen voneinander. Auf diese Weise kann zum Beispiel ein kantenemittierender Halbleiterlaser mit einem breitbandigen Emissionsspektrum realisiert werden.

Bei einer besonders bevorzugten Ausführungsform unterscheiden sich die Einfach- oder Mehrfach-Quantentopfstrukturen der mehreren aktiven Zonen in ihren Schichtdicken und/oder ihren Materialzusammensetzungen derart voneinander, dass eine durch Temperaturunterschiede der mehreren aktiven Zonen bedingte Differenz zwischen den Wellenlängen der von den mehreren aktiven Zonen emittierten Strahlung verringert oder sogar ganz kompensiert wird. Dies ist insbesondere dann vorteilhaft, wenn ein Laserstrahl mit sehr geringer spektraler Breite erwünscht ist, und trotz der bereits aufgrund der verringerten Dicke der inneren Mantelschichten reduzierten Temperaturunterschiede zwischen den verschiedenen aktiven Zonen noch geringfügige temperaturbedingte Abweichungen zwischen den Emissionswellenlängen der aktiven Zonen bestehen würden.

Bei einer bevorzugten Ausführungsform sind die Laserdioden durch Tunnelübergänge miteinander verbunden. Das Modenspektrum und damit die Intensitätsverteilung in Abhängigkeit von dem Abstrahlwinkel wird durch die Tunnelübergänge, welche für die emittierte Strahlung absorbierend wirken, beeinflusst. Aufgrund der im Vergleich zu herkömmlichen Halbleiterlasern verringerten Schichtdicke der inneren Mantelschichten kann nicht ausgeschlossen werden, dass die Strahlqualität des kantenemittierenden Halbleiterlasers durch eine Kopplung der Strahlung der mehreren aktiven Zonen beeinflusst wird.

Es hat sich aber herausgestellt, dass die trotz der verringerten Schichtdicke der inneren Mantelschichten erzielbare Strahlqualität für viele Anwendungen eines kantenemittierenden Halbleiterlasers ausreichend ist. Dies gilt insbesondere für Anwendungen, bei denen eine vergleichsweise hohe integrale Strahlungsintensität erwünscht ist, und das Strahlprofil nur eine untergeordnete Bedeutung hat. Ein erfindungsgemäßer Halbleiterlaser kann beispielsweise zum optischen Pumpen von Fasern eingesetzt werden.

Um eine durch die verringerten Dicken der Mantelschichten bedingte Absorption von Laserstrahlung in den Tunnelübergängen zu vermindern, ist es vorteilhaft, wenn die Tunnelübergänge mit einer geringen Schichtdicke ausgeführt werden. Vorteilhaft weisen die Tunnelübergänge eine Schichtdicke von 40 nm oder weniger auf. Weiterhin ist es vorteilhaft, wenn die inneren Mantelschichten jeweils eine Dicke von mindestens 10 nm aufweisen. Bei einer noch weiteren Verminderung der Dicke der inneren Mantelschichten würde ansonsten eine erhebliche Absorption der von den aktiven Zonen emittierten Laserstrahlung in den Tunnelübergängen stattfinden.

Bei einer weiteren bevorzugten Ausführungsform sind die Wellenleiterschichten unterschiedlich dick und/oder unterscheiden sich in ihren Materialzusammensetzungen. Auf diese Weise kann das Modenspektrum des Halbleiterlasers beeinflusst werden. Insbesondere kann durch eine geeignete Einstellung der Schichtdicken der Wellenleiterschichten erreicht werden, dass die Laserstrahlung in einer gewünschten Lasermode emittiert wird. Die Auswahl geeigneter Schichtdicken und/oder Materialzusammensetzungen für die Wellenleiterschichten und/oder die Mantelschichten erfolgt vorzugsweise anhand von Simulationsrechnungen. Insbesondere kann durch eine geeignete Auswahl der Schichtdicken und/oder der Materialzusammensetzungen der Fernfeldwinkel, also der Winkel, unter dem die Laserstrahlung im Fernfeld emittiert wird, verringert werden.

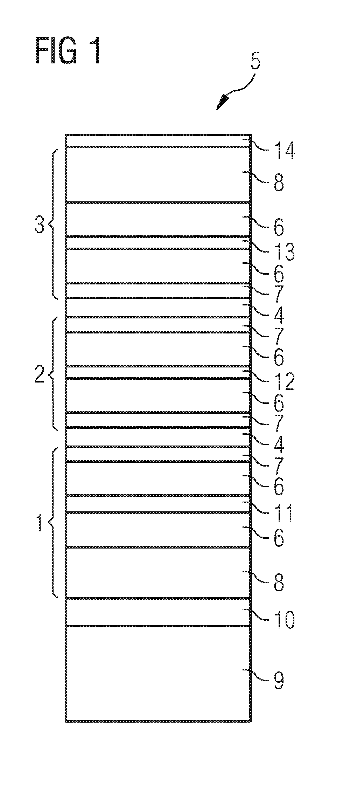

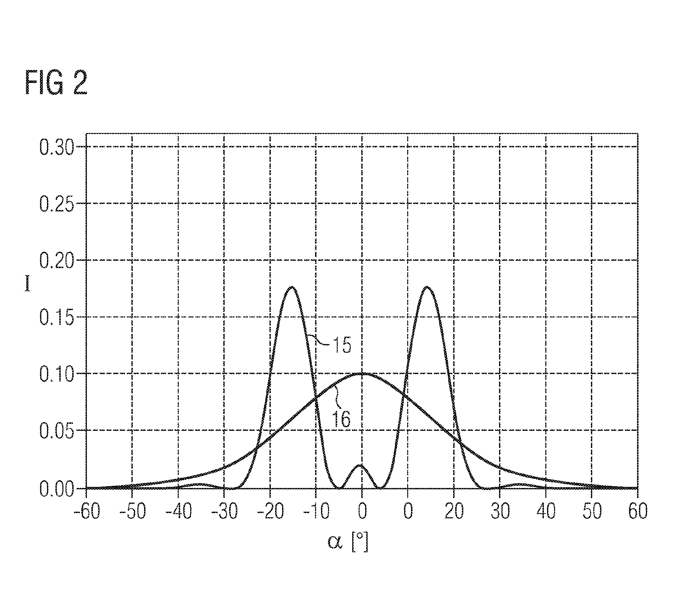

Die Erfindung wird im Folgenden anhand von zwei Ausführungsbeispielen im Zusammenhang mit den Figuren 1 und 2 näher erläutert.

Es zeigen:
- Figur 1: eine schematische grafische Darstellung eines Querschnitts durch einen kantenemittierenden Halbleiterlaser gemäß einem Ausführungsbeispiel der Erfindung, und
- Figur 2: eine grafische Darstellung des Strahlprofils eines kantenemittierenden Halbleiterlasers gemäß einem Ausführungsbeispiel der Erfindung im Vergleich zu einem herkömmlichen kantenemittierenden Halbleiterlaser.

Das in Figur 1 dargestellte Ausführungsbeispiel eines kantenemittierenden Halbleiterlasers gemäß der Erfindung enthält drei monolithisch integrierte Laserdioden 1, 2, 3.

Die Laserdioden 1, 2, 3 sind in einem gemeinsamen Schichtstapel 5 enthalten, der beispielsweise auf einem Substrat 9 aufgewachsen ist.

Die monolithisch integrierten Laserdioden 1, 2, 3 sind durch Tunnelübergänge 4 miteinander verbunden. Bei dem Ausführungsbeispiel ist zwischen der untersten Laserdiode 1 und der nachfolgenden Laserdiode 2 ein Tunnelübergang 4 enthalten. Ein weiterer Tunnelübergang 4 ist zwischen der Laserdiode 2 und der obersten Laserdiode 3 enthalten.

Jede der monolithisch integrierten Laserdioden enthält eine aktive Zone 11, 12, 13, die insbesondere aus einer Quantentopfstruktur gebildet sein kann. Die aktiven Zonen 11, 12, 13 sind jeweils zwischen zwei Wellenleiterschichten 6 angeordnet, die jeweils an die aktiven Zonen 11, 12, 13 angrenzen.

In jeder der monolithisch integrierten Laserdioden 1, 2, 3 grenzen die Wellenleiterschichten 6, die die aktiven Zonen 11, 12, 13 umgeben, jeweils an Mantelschichten 7, 8 an. Beispielsweise enthält die unterste Laserdiode 1 eine erste Mantelschicht 8, eine auf der ersten Mantelschicht 8 angeordnete erste Wellenleiterschicht 6, eine auf der ersten Wellenleiterschicht 6 angeordnete aktive Zone 11, eine auf der aktiven Zone 11 angeordnete zweite Wellenleiterschicht 6, und eine auf der zweiten Wellenleiterschicht 6 angeordnete zweite Mantelschicht 7. An die zweite Mantelschicht 7 der Laserdiode 1 schließt sich ein Tunnelübergang 4 an, auf dem die entsprechenden Schichten der zweiten Laserdiode 2 angeordnet sind. Auf die Laserdiode 2 folgt die dritte Laserdiode 3, wobei zwischen der Laserdiode 2 und der Laserdiode 3 ein weiterer Tunnelübergang 4 angeordnet ist.

Bei dem erfindungsgemäßen kantenemittierenden Halbleiterlaser weisen die inneren Mantelschichten 7 eine geringere Dicke auf als die äußeren Mantelschichten 8.

Unter den inneren Mantelschichten werden dabei diejenigen der innerhalb des Schichtstapels 5 enthaltenen Mantelschichten 7 verstanden, die oberhalb der aktiven Schicht 11 der untersten Laserdiode 1 und unterhalb der aktiven Schicht 13 der obersten Laserdiode 3 angeordnet sind.

Die äußeren Mantelschichten 8 sind erstens die Mantelschicht 8, die unterhalb der aktiven Zone 11 der untersten Laserdiode 1 angeordnet ist, und zweitens die Mantelschicht 8, die oberhalb der aktiven Zone 13 der obersten Laserdiode 3 angeordnet ist.

Die äußeren Mantelschichten 8 weisen vorzugsweise eine Dicke zwischen einschließlich 500 nm und einschließlich 2 µm auf. Beispielsweise können die beiden äußeren Mantelschichten 8 jeweils etwa 1300 nm dick sein.

Die inneren Mantelschichten 7 weisen bevorzugt eine Dicke von 300 nm oder weniger auf, besonders bevorzugt von 100 nm oder weniger. Beispielsweise können die inneren Mantelschichten 7 jeweils eine Dicke von 50 nm aufweisen.

Die vergleichsweise geringen Schichtdicken der inneren Mantelschichten 7, die insbesondere um ein Vielfaches dünner sind als die äußeren Mantelschichten 8, haben den Vorteil, dass der thermische Widerstand des Schichtstapels 5 verringert wird. Die von dem kantenemittierenden Halbleiterlaser erzeugte Wärme kann daher effizient über das Substrat 9 abgeführt werden. Beispielsweise kann der kantenemittierende Halbleiterlaser an einer Unterseite des Substrats 9 auf eine Wärmesenke montiert sein.

Weiterhin werden durch die vergleichsweise dünnen inneren Mantelschichten 7 in dem Schichtstapel 5 auftretende Verspannungen vermindert. Beispielsweise ist eine Gesamtdicke des Schichtstapels 5 mit den vier darin enthaltenen inneren Mantelschichten 7, die jeweils eine Dicke von nur 50 nm aufweisen, um 5 µm dünner als ein entsprechender Schichtstapel, bei dem die inneren Mantelschichten 7 mit der gleichen Schichtdicke wie die äußeren Mantelschichten 8, die zum Beispiel 1300 nm beträgt, ausgeführt wären.

Weiterhin haben die dünnen inneren Mantelschichten 7 den Vorteil, dass die aktiven Zonen 11, 12, 13 der Laserdioden 1, 2, 3 einen vergleichsweise geringen Abstand aufweisen. Dadurch werden Temperaturunterschiede der aktiven Zonen 11, 12, 13, die zu Differenzen in den Emissionswellenlängen führen könnten, vorteilhaft vermindert.

Aufgrund der zuvor genannten Vorteile der dünneren inneren Wellenleiterschichten 7 kann der Schichtstapel 5 auch eine größere Anzahl Laserdioden als drei aufweisen. Dies ist insbesondere dann vorteilhaft, wenn eine hohe Strahlungsleistung erwünscht ist.

Aufgrund der vergleichsweise dünnen inneren Mantelschichten 7 ist es möglich, dass ein Teil der in den aktiven Zonen 11, 12, 13 emittierten Strahlung in die Bereiche der Tunnelübergänge 4 eindringt. Um dadurch auftretende Absorptionsverluste gering zu halten, sind die inneren Mantelschichten 7 vorzugsweise nicht dünner als 10 nm.

Weiterhin ist es zur Vermeidung von Absorptionsverlusten in den Tunnelübergängen 4 vorteilhaft, auch die Tunnelübergänge vergleichsweise dünn auszuführen. Insbesondere kann die Dicke der Tunnelübergänge 40 nm oder weniger betragen.

Die aktiven Zonen 11, 12, 13 der Laserdioden 1, 2, 3 sind vorteilhaft als Einfach- oder Mehrfach-Quantentopfstruktur ausgeführt. Derartige Quantentopfstrukturen enthalten zum Beispiel eine Vielzahl von alternierenden Schichten, deren Materialzusammensetzung und Schichtdicken in Abhängigkeit von der erwünschten Emissionswellenlänge des Halbleiterlasers ausgewählt werden.

Bei einer Ausführungsform der Erfindung unterscheiden sich die Quantentopfstrukturen in ihren Schichtdicken und/oder ihrer Materialzusammensetzung voneinander. Auf diese Weise kann zum Beispiel erreicht werden, dass die mehreren monolithisch integrierten Laserdioden 1, 2, 3 verschiedene Emissionswellenlängen aufweisen.

Alternativ ist es auch möglich, dass sich die Quantentopfstrukturen in ihren Schichtdicken und/oder ihren Materialzusammensetzungen derart voneinander unterscheiden, dass aufgrund verschiedener Temperaturen der aktiven Zonen 11, 12, 13 der einzelnen Laserdioden 1, 2, 3 bedingte Unterschiede in der Emissionswellenlänge verringert oder sogar ganz kompensiert werden.

Bei einer weiteren vorteilhaften Variante weisen die Wellenleiterschichten 6 verschiedene Schichtdicken und/oder Materialzusammensetzungen auf. Die jeweiligen Schichtdicken der Wellenleiterschichten 6 können beispielsweise derart modifiziert werden, dass der Halbleiterlaser in einer gewünschten Lasermode anschwingt. Die jeweils erforderlichen Schichtdicken für die Wellenleiterschichten 6 können vor der Abscheidung des Schichtstapels 5 jeweils anhand von Simulationsrechnungen bestimmt werden. Durch eine Modifizierung der Dicke der Wellenleiterschichten 6 ist es auch möglich, einen Abstrahlwinkel des kantenemittierenden Halbleiterlasers zu verändern.

Das Substrat 9 ist vorzugsweise ein leitendes Substrat, beispielsweise ein dotiertes Halbleitersubstrat. Insbesondere kann das Substrat 9 ein n-dotiertes Substrat sein. Das Substrat 9 stellt dabei vorteilhaft einen ersten elektrisch leitenden Kontakt für den kantenemittierenden Halbleiterlaser dar. Ein weiterer elektrischer Kontakt 14 ist zum Beispiel auf eine dem Substrat gegenüberliegende Oberfläche des Schichtstapels 5 aufgebracht. Insbesondere kann es sich bei der Kontaktschicht 14 um eine p-Kontaktschicht handeln.

Das Substrat 9, auf dem der Schichtstapel 5 aufgewachsen ist, ist vorzugsweise mit einer Pufferschicht 10 versehen, die hinsichtlich der Schichtqualität und der Gitterkonstante eine zum epitaktischen Aufwachsen des Schichtstapels 12, der die Laserdioden 1, 2, 3 enthält, geeignete Aufwachsoberfläche ausbildet. Die Pufferschicht 10 kann beispielsweise eine Dicke von etwa 500 nm aufweisen.

Die Materialauswahl für den Schichtstapel 5, insbesondere für die darin enthaltenen aktiven Zonen 13, 14, 15, erfolgt anhand der gewünschten Emissionswellenlänge des Halbleiterlasers. Der Schichtstapel 5 basiert vorzugsweise auf einem III-V-Verbindungshalbleitermaterial, insbesondere auf einem Arsenid-, Nitrid- oder Phosphidverbindungshalbleitermaterial. Beispielsweise kann der Schichtstapel 5 InₓAl_{y}Ga_{1-x-y}N, InₓAl_{y}Ga_{1-x-y}P oder InₓAl_{y}Ga_{1-x-y}As, jeweils mit 0 ≤ x ≤ 1, 0 ≤ y ≤ 1 und x + y ≤ 1, enthalten. Dabei muss das III-V-Verbindungshalbleitermaterial nicht zwingend eine mathematisch exakte Zusammensetzung nach einer der obigen Formeln aufweisen. Vielmehr kann es einen oder mehrere Dotierstoffe sowie zusätzliche Bestandteile aufweisen, die die physikalischen Eigenschaften des Materials im wesentlichen nicht ändern. Der Einfachheit halber beinhalten obige Formeln jedoch nur die wesentlichen Bestandteile des Kristallgitters, auch wenn diese teilweise durch geringe Mengen weiterer Stoffe ersetzt sein können.

In Figur 2 ist das Strahlprofil (Kurve 15) eines Ausführungsbeispiels eines kantenemittierenden Halbleiterlasers gemäß der Erfindung, bei dem die inneren Mantelschichten eine Dicke von nur 150 nm aufweisen, im Vergleich zum Strahlprofil (Kurve 16) eines herkömmlichen Halbleiterlasers, bei dem die inneren Mantelschichten eine Schichtdicke von 1,35 µm aufweisen, dargestellt. Aufgetragen ist jeweils die Intensität I im Fernfeld des Halbleiterlasers (in willkürlichen Einheiten) gegenüber dem zur Hauptabstrahlrichtung gemessenen Abstrahlwinkel α.

Der herkömmliche Halbleiterlaser weist ein einziges Intensitätsmaximum in der Hauptstrahlrichtung, also bei α = 0° auf. Dagegen weist das Strahlprofil des erfindungsgemäßen Halbleiterlasers zwei ausgeprägte Intensitätsmaxima auf, die beidseitig der Hauptstrahlrichtung bei einem Winkel α von jeweils etwa 15° auftreten. Durch die geringen Dicken der inneren Mantelschichten ändert sich also das Strahlprofil im Fernfeld im Vergleich zu einem herkömmlichen Halbleiterlaser mit vergleichsweise dicken inneren Wellenleiterschichten.

Ein derartiges Strahlprofil kann für Anwendungen, in den eine geringe Strahlbreite erwünscht ist, nachteilig sein. Es hat sich aber herausgestellt, dass die integrale Intensität, die insgesamt in einen Abstrahlwinkelbereich von 50° emittiert wird, bei dem erfindungsgemäßen Halbleiterlaser größer ist als bei dem herkömmlichen Halbleiterlaser mit vergleichsweise dicken Wellenleiterschichten. Der erfindungsgemäße Halbleiterlaser eignet sich daher insbesondere für Anwendungen, bei denen die integrale Intensität eine größere Bedeutung hat als das Strahlprofil.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Kantenemittierender Halbleiterlaser, der mehrere monolithisch integrierte Laserdioden (1, 2, 3) enthält, wobei jede Laserdiode (1, 2, 3) eine aktive Zone (11, 12, 13) enthält,
**dadurch gekennzeichnet, dass**
- die aktiven Zonen (11, 12, 13) jeweils zwischen Wellenleiterschichten (6) angeordnet sind,
- die Wellenleiterschichten (6) an einer von der aktiven Zone (11, 12, 13) abgewandten Seite jeweils an eine Mantelschicht (7, 8) angrenzen, wobei die Mantelschichten innere Mantelschichten (7), die oberhalb einer untersten aktiven Zone (11) und unterhalb einer obersten aktiven Zone (13) angeordnet sind, und äußere Mantelschichten (8), die unterhalb der untersten aktiven Zone (11) oder oberhalb der obersten aktiven Zone (13) angeordnet sind, umfassen, und
- die inneren Mantelschichten (7) eine geringere Dicke aufweisen als die äußeren Mantelschichten (8).

2. Kantenemittierender Halbleiterlaser nach Anspruch 1,
**dadurch gekennzeichnet, dass**
die inneren Mantelschichten (7) um mindestens einen Faktor 2 dünner sind als die äußeren Mantelschichten (8) .

3. Kantenemittierender Halbleiterlaser nach Anspruch 2,
**dadurch gekennzeichnet, dass**
die inneren Mantelschichten (7) um mindestens einen Faktor 5 dünner sind als die äußeren Mantelschichten (8) .

4. Kantenemittierender Halbleiterlaser nach einem der vorhergehenden Ansprüche,
**dadurch gekennzeichnet, dass**
die inneren Mantelschichten (7) jeweils eine Dicke von 300 nm oder weniger aufweisen.

5. Kantenemittierender Halbleiterlaser nach Anspruch 4,
**dadurch gekennzeichnet, dass** die inneren Mantelschichten (7) jeweils eine Dicke von 100 nm oder weniger aufweisen.

6. Kantenemittierender Halbleiterlaser nach einem der vorhergehenden Ansprüche,
**dadurch gekennzeichnet, dass** die inneren Mantelschichten (7) jeweils eine Dicke von 10 nm oder mehr aufweisen.

7. Kantenemittierender Halbleiterlaser nach einem der vorhergehenden Ansprüche,
**dadurch gekennzeichnet, dass** die äußeren Mantelschichten (8) jeweils eine Dicke von 500 nm oder mehr aufweisen.

8. Kantenemittierender Halbleiterlaser nach Anspruch 7,
**dadurch gekennzeichnet, dass** die äußeren Mantelschichten (8) jeweils eine Dicke von 1 µm oder mehr aufweisen.

9. Kantenemittierender Halbleiterlaser nach einem der vorhergehenden Ansprüche,
**dadurch gekennzeichnet, dass**
eine Anzahl der monolithisch integrierten Laserdioden (1, 2, 3) vier oder mehr beträgt.

10. Kantenemittierender Halbleiterlaser nach einem der vorhergehenden Ansprüche,
**dadurch gekennzeichnet, dass** die aktiven Zonen (11, 12, 13) jeweils eine Quantentopfstruktur aufweisen.

11. Kantenemittierender Halbleiterlaser nach Anspruch 10,
**dadurch gekennzeichnet, dass** sich die Quantentopfstrukturen der mehreren aktiven Zonen (11, 12, 13) in ihren Schichtdicken und/oder ihren Materialzusammensetzungen voneinander unterscheiden.

12. Kantenemittierender Halbleiterlaser nach Anspruch 11,
**dadurch gekennzeichnet, dass** sich die Quantentopfstrukturen der mehreren aktiven Zonen (11, 12, 13) in ihren Schichtdicken und/oder ihren Materialzusammensetzungen derart voneinander unterscheiden, dass eine durch Temperaturunterschiede der mehreren aktiven Zonen (11, 12, 13) bedingte Differenz zwischen den Wellenlängen der von den mehreren aktiven Zonen (11, 12, 13) emittierten Strahlung verringert oder ganz kompensiert wird.

13. Kantenemittierender Halbleiterlaser nach einem der vorhergehenden Ansprüche,
**dadurch gekennzeichnet, dass** die Laserdioden (1, 2, 3) durch Tunnelübergänge (4) miteinander verbunden sind.

14. Kantenemittierender Halbleiterlaser nach Anspruch 13,
**dadurch gekennzeichnet, dass**
die Tunnelübergänge (4) jeweils eine Dicke von 40 nm oder weniger aufweisen.

15. Kantenemittierender Halbleiterlaser nach einem der vorhergehenden Ansprüche,
**dadurch gekennzeichnet, dass**
sich die Wellenleiterschichten (6) in ihren Schichtdicken und/oder ihren Materialzusammensetzungen voneinander unterscheiden.
